# EUROPEAN PATENT APPLICATION

(11) **EP 2 325 441 A2**
(43) Date of publication of application: **25.05.2011**
(21) Application number: 10251918.8
(22) Date of filing: 11.11.2010
(51) Int. Cl.: F01D 5/18, F01D 5/28, F01D 9/04

(54) **Gas turbine engine component with discontinuous coated areas and corresponding coating method**

(30) Priority: 13.11.2009 US 617741
(71) Applicant: United Technologies Corporation, Hartford, CT 06101 (US)
(72) Inventor: McCall, Thomas, New Britain, CT 06053 (US); Hiskes, David J., Vernon, CT 06066 (US); Miller, Michael L., Euless, TX 76039 (US); Lile, Scott C., Ellington, CT 06029 (US)
(74) Representative: Leckey, David Herbert

(57) **Abstract**

A turbine component has an airfoil (100) extending between a leading edge (56) and a trailing edge (60), and has an outer surface. A coating includes at least two discontinuous areas (54, 62) that are spaced from each other such that there is an area of uncoated surface between the discontinuous areas of coating.

## Description

### BACKGROUND OF THE INVENTION

This application relates to a method of providing protective coatings on a turbine component wherein discontinuous coating portions are provided at spaced locations on the component.

Gas turbine engines typically include a compressor which compresses air and delivers the compressed air into a combustion section. The air is mixed with fuel in the combustion section and burned. The products of this combustion pass downstream over turbine rotors, driving the rotors to power the engine.

The turbine rotors carry blades, and the blades rotate adjacent to static vanes. The vanes and blades have airfoils exposed to very high temperatures. Thus, coatings are provided to protect the blades and vanes and provide a longer life. Known coating may be provided across the entire surface of the airfoil. In another method, a single coating area is provided over a limited area on the airfoil. In either case, the coating has typically been provided at more locations than may require the coating.

The components are often repaired after a period of use.

### SUMMARY OF THE INVENTION

A turbine component has an airfoil extending between a leading edge and a trailing edge, and an outer surface. A coating includes at least two discontinuous portions that are spaced from each other such that there is an area of surface between the discontinuous portions of the coating. In addition, a method of providing such a coating is disclosed.

These and other features of the present invention can be best understood from the following specification and drawings, the following of which is a brief description.

### BRIEF DESCRIPTION OF THE DRAWINGS

Figure 1A shows a first prior art turbine component.
Figure 1B shows a second prior art turbine component.
Figure 2A shows a first view of an inventive component.
Figure 2B shows a second view of the inventive component.
Figure 3 is a top schematic view of the inventive turbine component.

### DETAILED DESCRIPTION OF THE PREFERRED EMBODIMENT

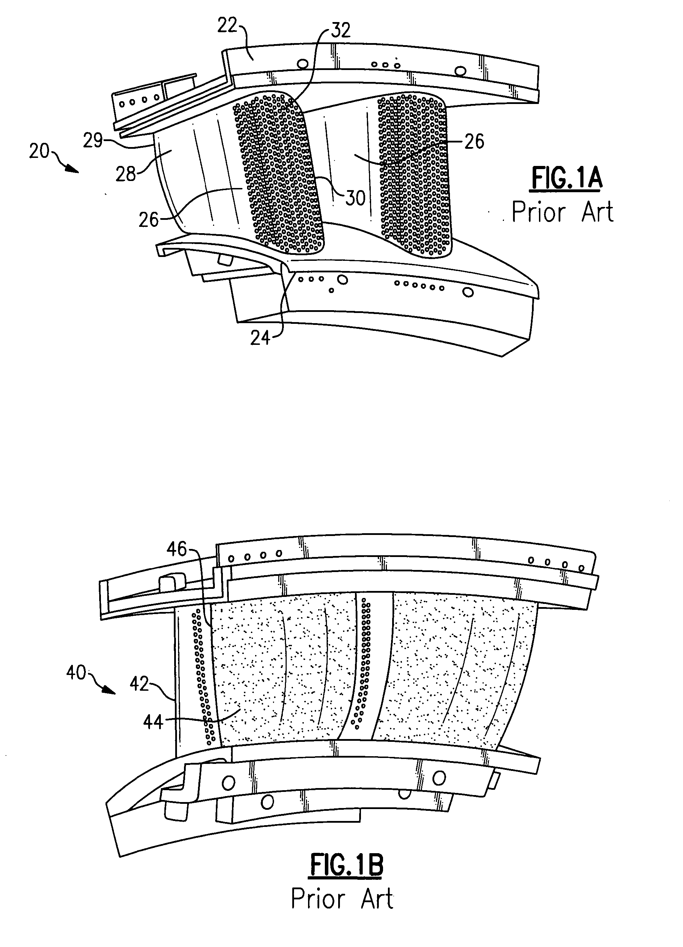

Figure 1A shows a prior art turbine component 20. The turbine component 20 as illustrated is a static vane having platforms 22 and 24, and airfoils 26 extending between the platforms. A pressure face 28 of the airfoil extends between a leading edge 32 and a trailing edge 29 on one side of the component, and a suction face (not shown) extends between the leading and trailing edges on another side.

In practice, it has often been the case that the entire airfoil (or surface that is exposed to hot gasses) would be provided with a protective coating, such as a thermal barrier coating. One such coating may be a ceramic coating. Any number of ceramic coatings may be utilized, and other thermal barrier coatings would also come within the scope of this invention. The coating is applied to an outer surface of the metal airfoil. Typically, the entire airfoil 26 has been coated.

Figure 1B shows another prior art airfoil 40 wherein the coating 44 extends to a rear end 46 spaced from an edge, such as the leading edge 42 and on a suction side.

When it has been determined that additional coating at an edge is necessary, typically the coating has wrapped from the suction side portion 44 around the leading edge and as a continuous coating portion.

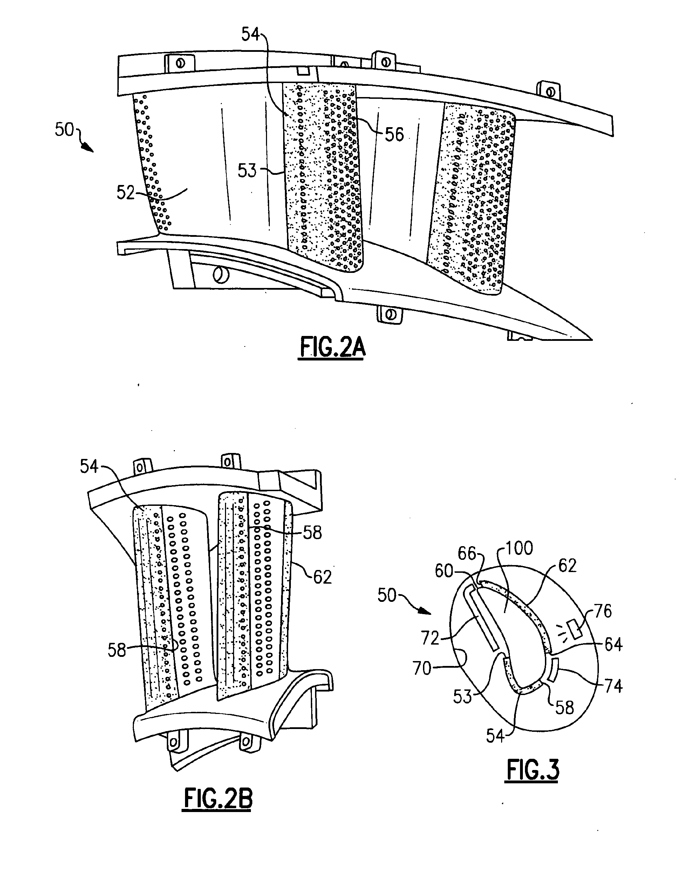

Figure 2A shows an embodiment 50, wherein the component has a pressure face 52, a coating area 54 extending from a pressure side rear end 53, wrapping around the leading edge 56, and to a leading edge end portion 58 as shown in Figure 2B. As shown in Figure 2B, another coating area 62 begins rearwardly of the end 58. Now, the coating portions 54 and 62 can be selected such that they are applied only over the areas of the component which most need the protection. As can be seen, an uncoated area sits between the coated areas 54 and 62. Although the term "end" has been mentioned, a worker of ordinary skill in this art would recognize that a "hard end" would typically not be achieved by such coating techniques, and that rather the coating would taper off.

In addition, another benefit of the disclosed invention is that distinct coatings can be utilized which are tailored to each specific location. A worker of ordinary skill in the art would recognize which coatings might be best for any individual location.

In this manner, the amount of coating applied to a part can be reduced. This reduces the weight of the component, and the overall cost of the coating. In addition, the coating can be applied only on the areas most needing the coating such that the lifespan of the component can be increased, as can the time between necessary repairs.

As shown in Figure 3, in a tool 70 for applying the coating, a physical vapor deposition element 76. (shown schematically) can be provided with sheet metal shadow masks 72 and 74. A worn and repaired airfoil 100 is shown being recoated. These masks will result in the coating portion 54 extending between its ends 53 and 58, and the rear coating portion 62 extending between ends 66 and 64. Notably, end 66 may be spaced from the trailing edge 60. An uncoated area remains between the facing ends 58 and 64, and along the suction side. The thickness of the coating is exaggerated to illustrate it.

The inventive method as illustrated in Figure 3 now allows a designer to carefully tailor the areas that receive the coating. In particular, this method is applicable to the repair of worn airfoils. In addition, the basic embodiment illustrated in Figure 3 would also be true of thermal spray coating techniques. Thermal spray coating builds the coating by built up splats.

As known, physical vapor deposition provides a columnar grain.

In fact, the present invention would extend to the application of the coating portions by any type of coating technique that would be applicable for non-metallic coatings.

Although an embodiment of this invention has been disclosed, a worker of ordinary skill in this art would recognize that certain modifications would come within the scope of this invention. For that reason, the following claims should be studied to determine the true scope and content of this invention.

## Claims

1. A gas turbine engine component (20) comprising:
an airfoil (100) extending between a leading edge (56) and a trailing edge (60), said airfoil being formed of a metal and having an outer surface; and
coating applied to said outer surface, said coating including at least two discontinuous coated areas (54, 62) that are spaced from each other such that there is an uncoated area of said outer surface between the discontinuous coated areas (54, 62) of said coating.

2. The component as set forth in claim 1, wherein a first coated area (62) is formed on a suction side of said outer surface and extends towards said leading edge (56), and a second coated area (54) wraps around said leading edge (56), said uncoated area being between said first and second coated areas (62, 54).

3. The component as set forth in claim 2, wherein said second coated area (54) wraps around said leading edge (56) and partially covers a pressure side (52) of said outer surface.

4. The component as set forth in any of claims 1 to 3, wherein said component (20) is a vane for use in a gas turbine engine.

5. The component as set forth in any preceding claim, wherein the coating includes a ceramic and wherein, optionally, the coating is a thermal barrier coating.

6. The component as set forth in any of claims 1 to 5, wherein said coating is applied by build-up splats through a thermal spray process, or wherein said coating is applied through physical vapor deposition and includes columnar grains.

7. The component as set forth in any of claims 1 to 6, wherein said at least two discontinuous coated areas (54, 62) are formed of two distinct coatings.

8. A method of coating a turbine component comprising the steps of:
providing an airfoil (100) extending between a leading edge (56) and a trailing edge (60), said airfoil (100) formed of a metal and having an outer surface; and
applying a coating to said outer surface, said coating including at least two discontinuous coated areas (54, 62) that are spaced from each other such that there is an uncoated area of said outer surface between the discontinuous coated areas (54, 62) of said coating.

9. The method as set forth in claim 8, wherein a first coated area (62) is formed on a suction side of said outer surface and extends towards said leading edge (56), and a second coated area (54) wraps around said leading edge (56), said uncoated area being between a space between said first (62) and second (54) coated areas.

10. The method as set forth in claim 9, wherein said second coated area (54) wraps around said leading edge (56) and partially covers a pressure side (52) of said outer surface.

11. The method as set forth in claims 8 to 10, wherein said component (20) is a vane for use in a gas turbine engine.

12. The method as set forth in claim 8 to 11, wherein the coating includes a ceramic and wherein optionally the coating is a thermal barrier coating.

13. The method as set forth in claims 8 to 12, wherein said coating is applied by a physical vapor deposition.

14. The method as set forth in claims 8 to 12, wherein said coating is applied by thermal spray coating techniques.

15. The method as set forth in claims 8 to 14, wherein distinct coatings are utilized for each of said at least two discontinuous coated areas (56, 62).
